# EUROPEAN PATENT APPLICATION

(11) **EP 3 937 596 A1**
(43) Date of publication of application: **12.01.2022**
(21) Application number: 19923992.2
(22) Date of filing: 11.04.2019
(51) Int. Cl.: H05K 1/02, H01P 3/08

(54) **COMMON MODE SUPPRESSION PACKAGING APPARATUS, AND PRINTED CIRCUIT BOARD**

(71) Applicant: Huawei Technologies Co., Ltd., Shenzhen, Guangdong 518129 (CN)
(72) Inventor: MA, Chao, Shenzhen, Guangdong 518129 (CN); FAN, Wenkai, Shenzhen, Guangdong 518129 (CN); CAI, Shujie, Shenzhen, Guangdong 518129 (CN)
(74) Representative: Gill Jennings & Every LLP
(86) International application number: PCT/CN2019/082335
(87) International publication number: WO 2020/206663

(57) **Abstract**

This application provides a common-mode suppression packaging apparatus and relates to suppression of common-mode noise during transmission of differential signals in the packaging apparatus. The packaging apparatus includes a substrate, and a power layer or ground layer, a pair of signal vias for transmitting differential signals, and a first via that are disposed in the substrate. The first via is disposed between the pair of signal vias, and at least a portion of the first via is located on a same horizontal plane as the pair of signal vias. One end of the first via is electrically connected to the power layer or ground layer, and other portions of the first via other than the end are insulated from surrounding media. The first via forms a resonant circuit in an electric field generated by common-mode signals, thereby suppressing the common-mode signals. A processing technique of the packaging apparatus is simple, and no additional filter trace is required, thereby being favorable to reduction of physical space occupied by the packaging apparatus, and reducing costs.

## Description

### TECHNICAL FIELD

This application relates to the field of semiconductors, and in particular, to the field of a common-mode suppression packaging apparatus and printed circuit board.

### BACKGROUND

For data at a rate of an order of magnitude of Gbps, a differential signal transmission technology is usually used in the industry to improve immunity of a signal to noise and suppress clock misalignment. Compared with a single-ended trace, a differential trace has excellent anti-noise performance, robustness to return path discontinuity, and an electromagnetic interference cancellation characteristic. Because of the foregoing features, the differential interconnection trace is widely applied to a basic standard of a high-speed link.

A signal transmitted by the differential interconnection trace includes not only a differential signal but also a common-mode signal (namely, common-mode noise). The differential signal is a signal difference between two signal traces of the differential interconnection trace. The common-mode signal is noise of the two signal traces to a ground, and is represented by an average voltage of two differential signals on the differential interconnection trace. In actual application, when a driver of the differential interconnection trace deviates from an ideal state, the signal transmitted by the differential interconnection trace encounters time misalignment. In addition, factors such as a trace length difference, an etching change, a proximity effect, and trace routing cause asymmetry of the differential interconnection trace, resulting in common-mode noise. Consequently, a high-speed circuit system encounters a signal integrity problem, a power integrity problem, and an electromagnetic interference problem.

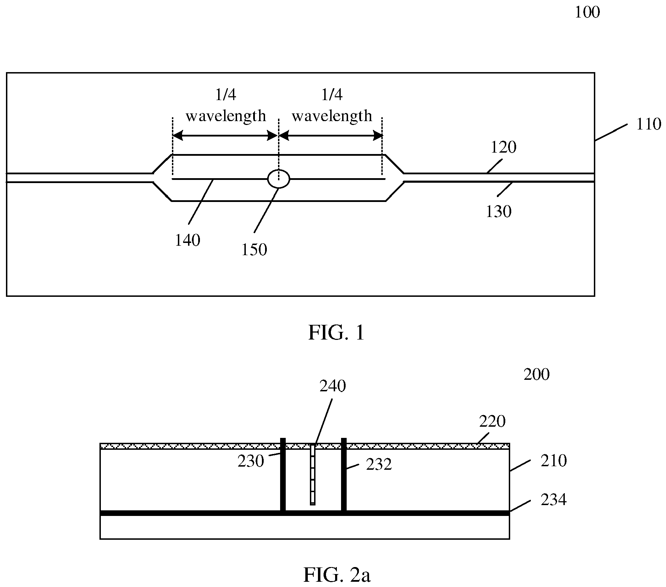

FIG. 1 is a schematic diagram of a signal layer of a common-mode noise suppression packaging apparatus 110 in the conventional technology. The packaging apparatus 110 includes a pair of differential traces (a differential interconnection trace), that is, a positive differential trace 120 and a negative differential trace 130, that are disposed in parallel on the signal layer in the packaging apparatus 110. A filter trace 140 is disposed between the two differential traces. A length of the filter trace 140 is 1/2 of a wavelength corresponding to noise that needs to be filtered out. A ground via 150 is further disposed at a middle point of the filter trace 140, and is connected to a reference ground plane of the packaging apparatus 110. In a region in which the filter trace 140 is disposed, a spacing between the positive differential trace 120 and the negative differential trace 130 is increased, to provide routing space for the filter trace 140. Although the packaging apparatus 110 shown in FIG. 1 has a good filtering characteristic within a specific frequency band, the packaging apparatus 110 has a relatively high requirement for control of a processing technique. In addition, the filter trace 140 and the ground via 150 occupy a large amount of physical space, which is unfavorable to miniaturization of the packaging apparatus 110.

### SUMMARY

Embodiments of this application provide a common-mode suppression packaging apparatus, to resolve the following problems resulting from suppression of common-mode noise in the packaging apparatus: a complex processing technique, waste of physical space, and excessively high costs.

To clearly describe the embodiments of this application, the following provides explanations of some terms.

Plane: In this application, a plane is a power layer or a ground layer in a packaging apparatus or a printed circuit board (PCB), and may be disposed on a surface layer or a middle layer.

Signal layer: In this application, a signal layer is a layer configured to arrange signal trace in a packaging apparatus or a PCB, or may be configured to dispose an element.

Anti-pad: An anti-pad is an empty region that is in a signal layer or a plane and that is formed after a medium around a via is removed, so that the via is insulated from a surrounding conductive medium.

According to a first aspect, an embodiment of this application provides a common-mode suppression packaging apparatus. The packaging apparatus includes a substrate, and a first plane, a first signal via, a second signal via, and a first common-mode suppression via that are disposed in the substrate. The first plane may be a ground layer or a power layer. The first signal via and the second signal via are differential signal vias and are configured to transmit differential signals. The first common-mode suppression via is disposed between the first signal via and the second signal via. Specifically, a first end of the first common-mode suppression via is electrically connected to the first plane, other portions of the first common-mode suppression via other than the first end are insulated from surrounding media, and at least a portion of the first common-mode suppression via is located on a same horizontal plane as the two signal vias. The first end of the first common-mode suppression via may be understood as a portion at which the first common-mode suppression via intersects with the first plane. The media surrounding the other portions of the first common-mode suppression via may be understood as a power layer, a ground layer, a signal layer, or an insulating material through which the other portions of the via other than the first end pass. The media may be a conducting wire or an insulating material disposed on the power layer, the ground layer, or the signal layer, or may be an insulating material between routing layers. When meeting the foregoing positional relationship, the first common-mode suppression via is located in an electric field formed by common-mode signals in the differential signal vias. Therefore, the first common-mode suppression via can suppress the common-mode signals. The substrate may be an interposer implemented by using a passive silicon wafer. It should be noted that the first via in the claims may be the first common-mode suppression via in the specification.

The common-mode signals transmitted in the first signal via and the second signal via form the electric field, and the first common-mode suppression via forms a resonant circuit in the electric field, thereby exciting a resonance characteristic of the common-mode signals, and suppressing the common-mode signals while retaining the differential signals. When the common-mode signals are suppressed by using the first common-mode suppression via, a requirement for a processing technique of the packaging apparatus is relatively simple, and no additional filter trace is required, thereby saving physical space and reducing costs.

In a possible implementing manner, the packaging apparatus further includes a second common-mode suppression via. Similar to the first common-mode suppression via, to enable the second common-mode suppression via to be located in the electric field formed by the common-mode signals in the differential signal vias, the second common-mode suppression via is disposed between the first signal via and the second signal via, a first end of the second common-mode suppression via is electrically connected to the first plane, and other portions of the second common-mode suppression via other than the first end are insulated from surrounding media. At least a portion of the second common-mode suppression via is located on a same horizontal plane as the two signal vias. The first end of the second common-mode suppression via may be understood as a portion at which the second common-mode suppression via intersects with the first plane. The media surrounding the other portions of the second common-mode suppression via may be understood as a power layer, a ground layer, a signal layer, or an insulating material through which the other portions of the via other than the first end pass. The media may be a conducting wire or an insulating material disposed on the power layer, the ground layer, or the signal layer, or may be an insulating material between routing layers. In addition, the first common-mode suppression via and the second common-mode suppression via are respectively disposed on two sides of a first virtual plane, and the first virtual plane is a plane passing through central axes of the two signal vias. Because both the two common-mode suppression vias disposed on the two sides of the first virtual plane are located in the electric field formed by the common-mode signals, the two common-mode suppression vias can form a better suppression effect on the common-mode signals. It should be noted that the second via in the claims may be the second common-mode suppression via in the specification.

In a possible implementing manner, both the first common-mode suppression via and the second common-mode suppression via may be obtained by performing back drill on a ground via or a power via in the packaging apparatus. The common-mode suppression vias can be obtained by directly performing back drill on the existing ground via or power via in the packaging apparatus, thereby simplifying the processing technique and further reducing costs of the packaging apparatus.

In a possible implementing manner, both a central axis of the first common-mode suppression via and a central axis of the second common-mode suppression via are located on a second virtual plane, and the second virtual plane is a virtual plane with respect to which the first signal via and the second signal via are symmetrical. For an electric field formed by the differential signals, the second virtual plane is a zero-potential plane, that is, may be considered as a virtual ground plane. When the central axes of the common-mode suppression vias are disposed on the second virtual plane, the common-mode suppression vias do not affect transmission of the differential signals, and suppress only the common-mode signals.

In a possible implementing manner, the first common-mode suppression via and the second common-mode suppression via are symmetrical with respect to the first virtual plane. When being symmetrically disposed with respect to the first virtual plane, the common-mode suppression vias can form a better suppression effect on the common-mode signals.

In a possible implementing manner, the packaging apparatus further includes a second plane, and the first common-mode suppression via and the second common-mode suppression via respectively pass through the second plane. The first common-mode suppression via and the second common-mode suppression via are kept isolated from the second plane by a first anti-pad and a second anti-pad that are disposed on the second plane, respectively, and the second plane is a ground layer or a power layer. When the common-mode suppression vias are kept isolated from the another plane in the substrate by the anti-pads, the common-mode suppression vias have valid lengths matching frequencies of the common-mode signals, to form a valid resonant circuit.

In a possible implementing manner, both the first plane and the second plane are ground layers, and the packaging apparatus further includes a ground via disposed in the substrate. The ground via is electrically connected to the first plane and the second plane. The packaging apparatus may further include the ground via, and the ground via and the common-mode suppression vias do not affect each other.

In a possible implementing manner, the packaging apparatus further includes a signal layer, one end of the first signal via and one end of the second signal via are respectively and electrically connected to the signal layerrespectively, and the first common-mode suppression via and the second common-mode suppression via respectively pass through the signal layer, and are kept isolated from the signal layer by a third anti-pad and a fourth anti-pad that are disposed on the signal layer, respectively. When the common-mode suppression vias are kept isolated from the another signal layer in the substrate by the anti-pads, the common-mode suppression vias have the valid lengths matching the frequencies of the common-mode signals, to form the valid resonant circuit.

In a possible implementing manner, the packaging apparatus further includes a die and a first metal connector that are disposed on one side of the substrate, and the die is electrically connected to the first signal via, the second signal via, and the first plane by using the first metal connector. The packaging apparatus is electrically connected to the die, so that the signals in the packaging apparatus can be transmitted to the die for processing.

In a possible implementing manner, the packaging apparatus further includes a second metal connector disposed on the other side of the substrate, and the packaging apparatus is electrically connected to a printed circuit board PCB by using the second metal connector. The packaging apparatus is electrically connected to the PCB, so that the signals in the packaging apparatus can be transmitted to, through the PCB, another circuit connected to the PCB.

According to a second aspect, an embodiment of this application provides a common-mode suppression printed circuit board PCB. The PCB includes a substrate, and a first plane, a first signal via, a second signal via, and a first common-mode suppression via that are disposed in the substrate. The first plane may be a ground layer or a power layer. The first signal via and the second signal via are differential signal vias and are configured to transmit differential signals. The first common-mode suppression via is disposed between the first signal via and the second signal via. Specifically, a first end of the first common-mode suppression via is electrically connected to the first plane, other portions of the first common-mode suppression via other than the first end are insulated from surrounding media, and at least a portion of the first common-mode suppression via is located on a same horizontal plane as the two signal vias. The first end of the first common-mode suppression via may be understood as a portion at which the first common-mode suppression via intersects with the first plane. The media surrounding the other portions of the first common-mode suppression via may be understood as a power layer, a ground layer, a signal layer, or an insulating material through which the other portions of the via other than the first end pass. The media may be a conducting wire or an insulating material disposed on the power layer, the ground layer, or the signal layer, or may be an insulating material between routing layers. When meeting the foregoing positional relationship, the first common-mode suppression via is located in an electric field formed by common-mode signals in the differential signal vias. Therefore, the first common-mode suppression via can suppress the common-mode signals. The substrate may be a PCB implemented by using a copper-clad foil laminate. It should be noted that the first via in the claims may be the first common-mode suppression via in the specification.

The common-mode signals transmitted in the first signal via and the second signal via form the electric field, and the first common-mode suppression via forms a resonant circuit in the electric field, thereby exciting a resonance characteristic of the common-mode signals, and suppressing the common-mode signals while retaining the differential signals. When the common-mode signals are suppressed by using the first common-mode suppression via, a requirement for a processing technique of the PCB is relatively simple, and no additional filter trace is required, thereby saving physical space and reducing costs.

In a possible implementing manner, the PCB further includes a second common-mode suppression via. Similar to the first common-mode suppression via, to enable the second common-mode suppression via to be located in the electric field formed by the common-mode signals in the differential signal vias, the second common-mode suppression via is disposed between the first signal via and the second signal via, a first end of the second common-mode suppression via is electrically connected to the first plane, and other portions of the second common-mode suppression via other than the first end are insulated from surrounding media. At least a portion of the second common-mode suppression via is located on a same horizontal plane as the two signal vias. The first end of the second common-mode suppression via may be understood as a portion at which the second common-mode suppression via intersects with the first plane. The media surrounding the other portions of the second common-mode suppression via may be understood as a power layer, a ground layer, a signal layer, or an insulating material through which the other portions of the via other than the first end pass. The media may be a conducting wire or an insulating material disposed on the power layer, the ground layer, or the signal layer, or may be an insulating material between routing layers. In addition, the first common-mode suppression via and the second common-mode suppression via are respectively disposed on two sides of a first virtual plane, and the first virtual plane is a plane passing through central axes of the two signal vias. Because both the two common-mode suppression vias disposed on the two sides of the first virtual plane are located in the electric field formed by the common-mode signals, the two common-mode suppression vias can form a better suppression effect on the common-mode signals. It should be noted that the second via in the claims may be the second common-mode suppression via in the specification.

In a possible implementing manner, both the first common-mode suppression via and the second common-mode suppression via may be obtained by performing back drill on a ground via or a power via in the PCB. The common-mode suppression vias can be obtained by directly performing back drill on the existing ground via or power via in the PCB, thereby simplifying the processing technique and further reducing costs of the PCB.

In a possible implementing manner, both a central axis of the first common-mode suppression via and a central axis of the second common-mode suppression via are located on a second virtual plane, and the second virtual plane is a virtual plane with respect to which the first signal via and the second signal via are symmetrical. For an electric field formed by the differential signals, the second virtual plane is a zero-potential plane, that is, may be considered as a virtual ground plane. When the central axes of the common-mode suppression vias are disposed on the second virtual plane, the common-mode suppression vias do not affect transmission of the differential signals, and suppress only the common-mode signals.

In a possible implementing manner, the first common-mode suppression via and the second common-mode suppression via are symmetrical with respect to the first virtual plane. When being symmetrically disposed with respect to the first virtual plane, the common-mode suppression vias can form a better suppression effect on the common-mode signals.

In a possible implementing manner, the PCB further includes a second plane, and the first common-mode suppression via and the second common-mode suppression via respectively pass through the second plane. The first common-mode suppression via and the second common-mode suppression via are kept isolated from the second plane by a first anti-pad and a second anti-pad that are disposed on the second plane, respectively, and the second plane is a ground layer or a power layer. When the common-mode suppression vias are kept isolated from the another plane in the substrate by the anti-pads, the common-mode suppression vias have valid lengths matching frequencies of the common-mode signals, to form a valid resonant circuit.

In a possible implementing manner, both the first plane and the second plane are ground layers, and the PCB further includes a ground via disposed in the substrate. The ground via is electrically connected to the first plane and the second plane. The PCB may further include the ground via, and the ground via and the common-mode suppression vias do not affect each other.

In a possible implementing manner, the PCB further includes a signal layer, one end of the first signal via and one end of the second signal via are respectively and electrically connected to the signal layerrespectively, and the first common-mode suppression via and the second common-mode suppression via respectively pass through the signal layer, and are kept isolated from the signal layer by a third anti-pad and a fourth anti-pad that are disposed on the signal layer, respectively. When the common-mode suppression vias are kept isolated from the another signal layer in the substrate by the anti-pads, the common-mode suppression vias have the valid lengths matching the frequencies of the common-mode signals, to form the valid resonant circuit.

### BRIEF DESCRIPTION OF DRAWINGS

To describe technical solutions in embodiments of this application or in the conventional technology more clearly, the following briefly describes accompanying drawings used for describing the embodiments or the conventional technology.
FIG. 1 shows a common-mode noise suppression packaging apparatus in the conventional technology;
FIG. 2a is a schematic sectional view of a packaging apparatus according to an embodiment of this application;
FIG. 2b is a top view of a packaging apparatus according to an embodiment of this application;
FIG. 3a is a schematic back drill sectional view of a packaging apparatus according to an embodiment of this application;
FIG. 3b is another schematic back drill sectional view of a packaging apparatus according to an embodiment of this application;
FIG. 4 is another top view of a packaging apparatus according to an embodiment of this application;
FIG. 5a is a diagram of an electric field generated by common-mode signals in a packaging apparatus according to an embodiment of this application;
FIG. 5b is a diagram of an electric field generated by differential signals in a packaging apparatus according to an embodiment of this application;
FIG. 6 is a more specific schematic sectional view of a packaging apparatus according to an embodiment of this application;
FIG. 7 is another more specific schematic sectional view of a packaging apparatus according to an embodiment of this application;
FIG. 8 is a simulation diagram of a common-mode insertion loss of a packaging apparatus according to an embodiment of this application; and
FIG. 9 is a schematic sectional view of a printed circuit board according to an embodiment of this application.

Description of reference numerals in the accompanying drawings: packaging apparatus 200; substrate 210; first plane 220; first via 222; second plane 224; third plane 226; first signal via 230; second signal via 232; first signal layer 234; first common-mode suppression via 240; second common-mode suppression via 242; first anti-pad 246; second anti-pad 248; die 250; first metal connector 252; second metal connector 254; and printed circuit board 256.

### DESCRIPTION OF EMBODIMENTS

The following clearly describes technical solutions in embodiments of this application with reference to accompanying drawings in the embodiments of this application.

FIG. 2a is a schematic sectional view of a common-mode suppression packaging apparatus 200 according to this application. The packaging apparatus 200 includes a substrate 210, and a first signal layer 234, a first plane 220, a first signal via 230, a second signal via 232, and a first common-mode suppression via 240 that are disposed in the substrate 210. The first signal via 230 and the second signal via 232 are differential signal vias and are configured to transmit differential signals. One end of the first signal via 230 and one end of the second signal via 232 may be respectively and electrically connected to the first signal layer 234 disposed in the substrate 210, and the other ends of the first signal via 230 and the second signal via 232 are electrically connected to another signal layer, or are electrically connected to a circuit outside the packaging apparatus 200, for example, are electrically connected to an external Printed Circuit Board (PCB) or a die. The first common-mode suppression via 240 is disposed between the first signal via 230 and the second signal via 232. A first end of the first common-mode suppression via 240 is electrically connected to the first plane 220, and other portions of the first common-mode suppression via 240 other than the first end are insulated from surrounding media. The first end of the first common-mode suppression via 240 may be understood as a portion at which the first common-mode suppression via 240 intersects with the first plane 220. The media surrounding the other portions of the first common-mode suppression via 240 may be understood as a power layer, a ground layer, a signal layer, or an insulating material through which the other portions of the via other than the first end pass. The media may be a conducting wire or an insulating material disposed on the power layer, the ground layer, or the signal layer, or may be an insulating material between routing layers. In the packaging apparatus 200 shown in FIG. 2a, the media surrounding the other portions of the first common-mode suppression via 240 other than the first end may be understood as a portion that is of the substrate 210 and through which the first common-mode suppression via 240 passes. In addition, at least a portion of the first common-mode suppression via 240 in a vertical direction (that is, along a direction of the via) is located on a same horizontal plane as the first signal via 230 and the second signal via 232. In other words, at least one virtual plane perpendicular to the direction of the via cuts both the two common-mode suppression vias and the two signal vias. The first plane 220 may be a ground layer that provides a reference ground, or a power layer that provides a working voltage.

In addition to the differential signals, there are also common-mode signals (namely, common-mode noise) in the first signal via 230 and the second signal via 232. The differential signals and the common-mode signals respectively generate different electric fields. Because the first common-mode suppression via 240 is disposed between the first signal via 230 and the second signal via 232, the first end of the first common-mode suppression via 240 is electrically connected to the first plane 220, and the other portions of the first common-mode suppression via 240 are insulated from the surrounding media, the first common-mode suppression via 240 forms a resonant circuit in the electric field generated by the common-mode signals, thereby exciting a resonance characteristic of the common-mode signals in the first signal via 230 and the second signal via 232, and suppressing the common-mode signals while retaining the differential signals. Compared with a manner in the conventional technology in which common-mode suppression is implemented by using a filter trace and an additional ground via, a manner in this application in which common-mode noise is suppressed by using the first common-mode suppression via 240 has a relatively simple requirement for a processing technique, and does not require an additional filter trace, thereby reducing physical space occupied by the packaging apparatus 200, being favorable to miniaturization of the packaging apparatus 200, and reducing manufacturing costs of the packaging apparatus 200.

It should be noted that for the first common-mode suppression via 240, only the first end is electrically connected to the first plane 220, and all the other portions are isolated from a signal layer, a plane, or another conductive medium around the via. The signal vias and the common-mode suppression via may respectively be through holes, blind holes, or buried holes. In an implementing manner, the first plane 220 may be a first layer of the packaging apparatus 200, that is, be disposed on one of surfaces of the packaging apparatus 200; and in this case, the first common-mode suppression via 240 may be a through hole, that is, a length of the first common-mode suppression via 240 is the same as a thickness of the packaging apparatus 200, or the first common-mode suppression via 240 may be a blind hole, that is, a length of the first common-mode suppression via 240 is less than a thickness of the packaging apparatus 200. Alternatively, the first plane 220 may be a middle layer disposed inside the packaging apparatus 200, and in this case, the first common-mode suppression via 240 may be a blind hole or a buried hole. The substrate 210 may be an interposer implemented by using a passive silicon wafer.

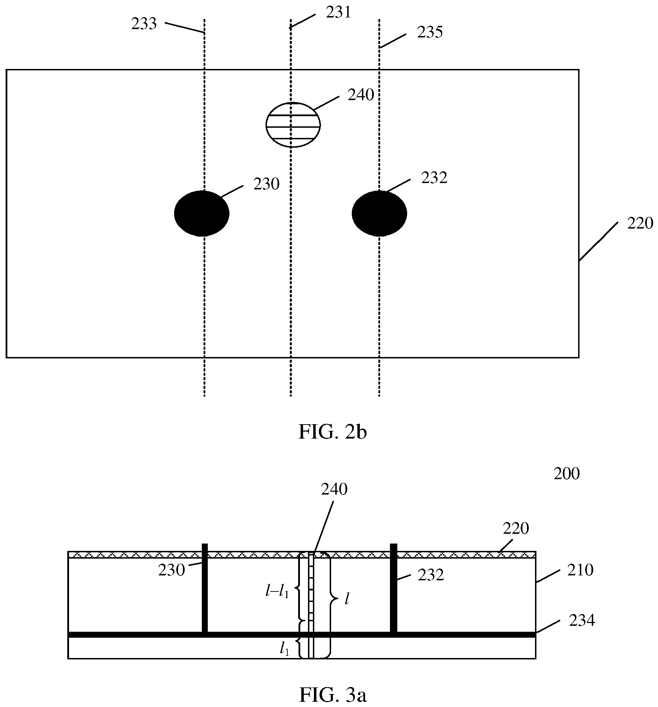

FIG. 2b is a top view of the packaging apparatus 200. The first signal via 230 and the second signal via 232 are symmetrical with respect to a second virtual plane 231. The second virtual plane 231 is a plane that is perpendicular to the substrate 210 (or perpendicular to the plane or signal layer) and passes through a central axis of the first common-mode suppression via 240. The first common-mode suppression via 240 is disposed between a third virtual plane 233 and a fourth virtual plane 235, for example, disposed between the third virtual plane 233 and the second virtual plane 231, or disposed between the second virtual plane 231 and the fourth virtual plane 235. The third virtual plane 233 is a plane that is perpendicular to the substrate 210 and that passes through a central axis of the first signal via 230. The fourth virtual plane 235 is a plane that is perpendicular to the substrate 210 and that passes through a central axis of the second signal via 232. The third virtual plane 233 and the fourth virtual plane 235 are two planes symmetrical with respect to the second virtual plane 231. A location of the first common-mode suppression via 240 is related to a common-mode suppression effect. When the first common-mode suppression via 240 is closer to the second virtual plane 231, the common-mode suppression effect is better. In an implementing manner, the central axis of the first common-mode suppression via 240 is located on the second virtual plane 231.

In an implementing manner, the length of the first common-mode suppression via 240 is less than the thickness (along the direction of the via) of the packaging apparatus 200, and the first common-mode suppression via 240 may be obtained by performing back -drill on a ground via or a power via in the packaging apparatus 200. The ground via is used as an example. FIG. 3a is a schematic back drill sectional view of the packaging apparatus 200. The thickness (along the direction of the via) of the packaging apparatus 200 is *l,* and a length of the ground via is also *l.* Back drill is performed on the ground via in a direction from a lower surface of the packaging apparatus 200, that is, a surface that is far away from the first plane 220, toward the first plane 220, and a back drill length is *l*₁. For the ground via obtained after back drill, a conductive material (for example, a copper layer) on an inner wall surface of a via portion with a length of *l*₁ is ground away, so that the ground via portion whose inner wall is ground away is not conductive. In this case, in the ground via, only a ground via portion *l*- *l*₁ shown in FIG. 3a retains a conductive material on an inner wall. The portion with the length of *l*- *l*₁ is the first common-mode suppression via 240, whereas the portion that is obtained after back drill and that has the length of *l*₁ does not belong to the first common-mode suppression via 240.

In another implementing manner, the length of the first common-mode suppression via 240 is equal to the thickness *l* of the packaging apparatus 200, that is, no back drill is performed on a ground via. In this case, the entire ground via may be considered as the first common-mode suppression via 240. The length of the first common-mode suppression via 240 may be controlled for common-mode signals of different frequencies, that is, a back drill length may be controlled based on a frequency of common-mode noise, to implement better common-mode suppression. For example, when the length *l*- *l*₁ of the first common-mode suppression via 240 is 0.8 mm, a 3 dB filtering band corresponding to the length is 22.55 GHz to 27.24 GHz, and in this case, common-mode suppression of a bandwidth of 4.69 GHz can be implemented; or when the length *l*- *l*₁ of the first common-mode suppression via 240 is 0.7 mm, a 3 dB filtering band corresponding to the length is 28.80 GHz to 34.86 GHz, and in this case, common-mode suppression of a bandwidth of 6.06 GHz can be implemented.

It should be noted that in the schematic sectional view of the packaging apparatus 200 shown in FIG. 3a, the ground-off via portion with the length of *l*₁ does not belong to the first common-mode suppression via 240, and the length of the first common-mode suppression via 240 should be understood as the length, namely, *l*- *l*₁, of the via portion that has the conductive material on the inner wall surface. For the first common-mode suppression via 240, only the first end is electrically connected to the first plane 220, and all the other portions (including the other end) are isolated from a surrounding signal layer, a plane, or another conductive medium, and do not form electrical connections in any form. Therefore, after back drill is performed on the ground via, if one end of the ground via is electrically connected to another plane, the other end of the ground via is insulated from a surrounding medium, and a middle portion of the ground via is electrically connected to the first plane 220, a ground via portion from the other end to the first plane 220 is the first common-mode suppression via 240, and a ground via portion from the first plane 220 to the another plane does not belong to the first common-mode suppression via 240.

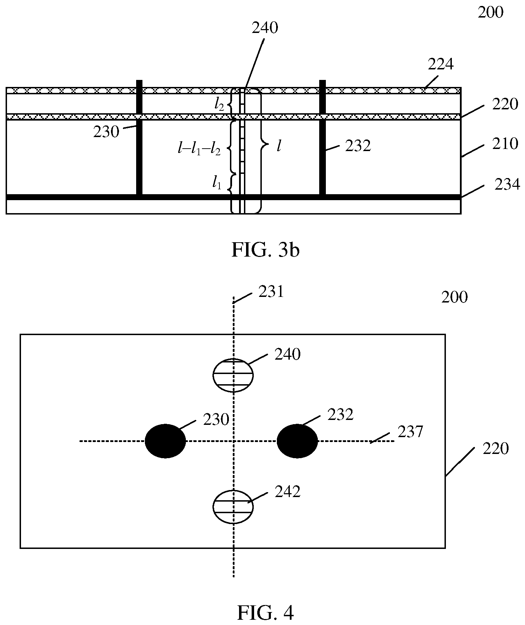

For example, in a schematic sectional view of the packaging apparatus 200 shown in FIG. 3b, the packaging apparatus 200 further includes a second plane 224. The second plane 224 is disposed on a side that is of the first plane 220 and that is far away from the first signal layer 234. The second plane 224 may be a surface layer of the packaging apparatus 200. One end of a ground via with a length of *l* is connected to the second plane 224. A back drill manner and a back drill length of the ground via are the same as a back drill manner and the back drill length of the ground via in the packaging apparatus 200 in FIG. 3a, respectively. Because the ground via is respectively and electrically connected to the first plane 220 and the second plane 224 between which a spacing is *l*₂, the first common-mode suppression via 240 in the packaging apparatus 200 is a ground via portion with a length of *l*- *l*₁ - *l*₂. That is, the first end of the first common-mode suppression via 240 should be a portion at which the ground via intersects with the first plane 220.

This application further provides another top view of the packaging apparatus 200 shown in FIG. 4. The packaging apparatus 200 further includes a second common-mode suppression via 242, disposed between the first signal via 230 and the second signal via 232. A first end of the second common-mode suppression via 242 is electrically connected to the first plane 220, and other portions of the second common-mode suppression via 242 other than the first end are insulated from surrounding media. The first end of the second common-mode suppression via 242 may be understood as a portion at which the second common-mode suppression via 242 intersects with the first plane 220. The media surrounding the other portions of the second common-mode suppression via 242 may be understood as a power layer, a ground layer, a signal layer, or an insulating material through which the other portions of the via other than the first end pass. The media may be a conducting wire or an insulating material disposed on the power layer, the ground layer, or the signal layer, or may be an insulating material between routing layers. The first common-mode suppression via 240 and the second common-mode suppression via 242 are respectively disposed on two sides of a first virtual plane 237. The first virtual plane 237 is a plane that passes through both central axes of the first signal via 230 and the second signal via 232 and that is perpendicular to the substrate 210. When the two common-mode suppression vias are respectively disposed on the two sides of the first virtual plane 237, it is favorable for the packaging apparatus 200 to better suppress the common-mode signals in the vias. In an implementing manner, both the central axis of the first common-mode suppression via 240 and a central axis of the second common-mode suppression via 242 are located on the second virtual plane 231, that is, located on a symmetry plane of the first signal via 230 and the second signal via 232. In an implementing manner, the first common-mode suppression via 240 and the second common-mode suppression via 242 are further symmetrical with respect to the first virtual plane 237. Similar to the first common-mode suppression via 240, the second common-mode suppression via 242 may also be obtained by performing back drill on an ordinary ground via or power via. Details are not described herein again.

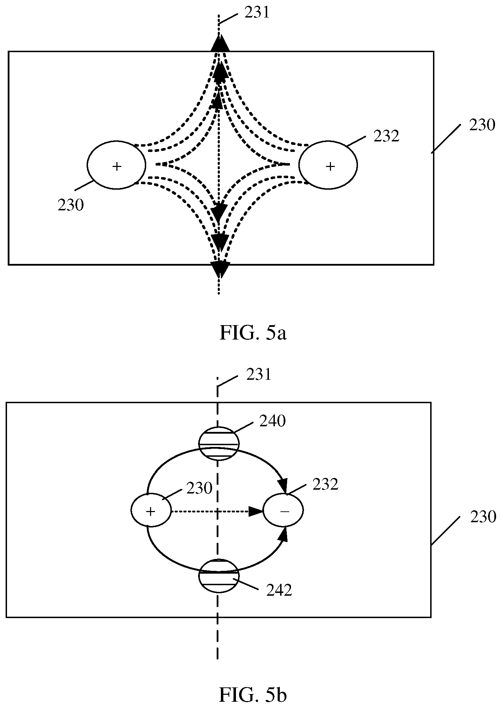

When the first signal via 230 and the second signal via 232 transmit common-mode signals, distribution of an electric field formed by the common-mode signals is shown in FIG. 5a. Because the common-mode signals have a same magnitude and are in a same direction, a direction of the electric field generated by the first signal via 230 and the second signal via 232 is from a signal via (for example, the first signal via 230 or the second signal via 232) to the second virtual plane 231. The first common-mode suppression via 240 and the second common-mode suppression via 242 form a resonant circuit, thereby exciting a resonance characteristic of the common-mode signals, and suppressing transmission of the common-mode signals in the first signal via 230 and the second signal via 232. To enable the first common-mode suppression via 240 and the second common-mode suppression via 242 to be located in the electric field, locations of the first common-mode suppression via 240 and the second common-mode suppression via 242 in a vertical direction (that is, along directions of the vias) need to match the first signal via 230 and the second signal via 232. Specifically, at least one virtual plane perpendicular to the directions of the vias cuts both the two common-mode suppression vias and the two signal vias. In other words, the packaging apparatus 200 includes at least one metal layer, and all of the two common-mode suppression vias and the two signal vias pass through the metal layer.

FIG. 5b is a diagram of distribution of an electric field formed by differential signals when the differential signals are transmitted by the first signal via 230 and the second signal via 232. Because the differential signals have a same magnitude and are in opposite directions, a direction of the electric field generated by the first signal via 230 and the second signal via 232 is from a via in a positive direction (for example, the first signal via 230) to a via in a negative direction (for example, the second signal via 232), and a zero-potential plane, namely, a virtual ground plane, is formed on the symmetry plane (namely, the second virtual plane 231) of the first signal via 230 and the second signal via 232. When the first common-mode suppression via 240 and the second common-mode suppression via 242 are located on the second virtual plane 231, it is equivalent to that the first common-mode suppression via 240 and the second common-mode suppression via 242 are connected to a ground plane in electrical performance. Therefore, the differential signals are not affected while the common-mode signals are suppressed.

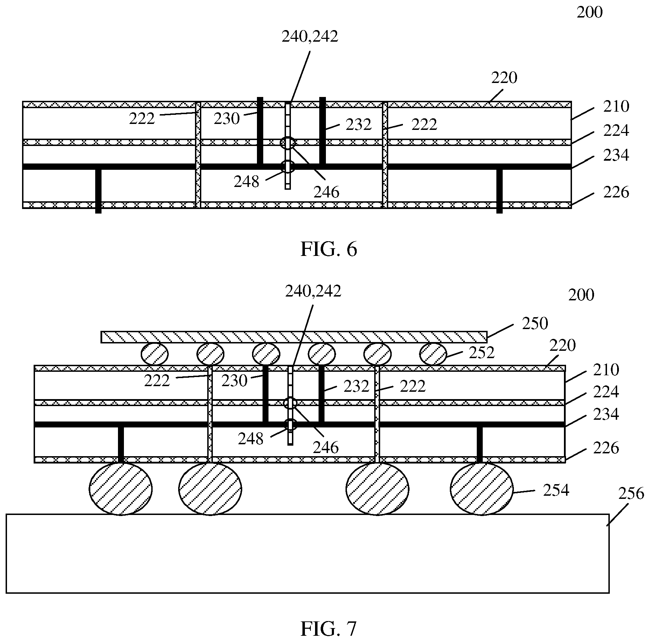

FIG. 6 shows a specific implementing manner of the packaging apparatus 200. The packaging apparatus 200 further includes a second plane 224, a third plane 226, and a first signal layer 234 that are disposed in the substrate 210. The second plane 224 is disposed on a side of a first plane 220, and the third plane 226 is disposed on a side that is of the second plane 224 and that is away from the first plane 220. The first plane 220, the second plane 224, and the third plane 226 may respectively be a ground layer or a power layer. The first common-mode suppression via 240 and the second common-mode suppression via 242 respectively pass through the second plane 224 and are respectively kept isolated from the second plane 224. In an implementing manner, the first common-mode suppression via 240 and the second common-mode suppression via 242 are respectively kept isolated from the second plane 224 by two first anti-pads 246 disposed on the second plane 224. Specifically, to prevent the common-mode suppression vias from forming an electrical connection to the plane, conductive media that are around the vias and that are on the plane are removed to form the anti-pads. The third plane 226 may be a last layer of the packaging apparatus 200, that is, disposed on a surface that is of the packaging apparatus 200 and that is far away from the first plane 220, or may be a middle layer disposed inside the packaging apparatus 200.

In an implementing manner, all of the first plane 220, the second plane 224, and the third plane 226 are ground layers, and the packaging apparatus 200 further includes a first via 222. In this case, the first via 222 is a ground via. One end of the first via 222 is electrically connected to the first plane 220, the first via 222 passes through the second plane 224, and the other end of the first via 222 is electrically connected to the third plane 226. The first signal layer 234 may be disposed between the first plane 220 and the second plane 224, or may be disposed between the second plane 224 and the third plane 226. In an implementing manner, one end of the first signal via 230 and one end of the second signal via 232 are respectively and electrically connected to the signal layer234 respectively, and the other end of the first signal via 230 and the other end of the second signal via 232 may be electrically connected to an external circuit by using metal pieces, for example, solder bumps. In another implementing manner, all of the first plane 220, the second plane 224, and the third plane 226 are power layers. In this case, the first via 222 is a power via.

In an implementing manner, the first common-mode suppression via 240 and the second common-mode suppression via 242 respectively pass through the first signal layer 234, and are respectively kept isolated from the signal plane 234 by two second anti-pads 248 disposed on the first signal layer 234.

FIG. 7 shows a more specific implementing manner of the packaging apparatus 200. The packaging apparatus 200 further includes a die 250 and a first metal connector 252 that are disposed on one side of the substrate. In an implementing manner, the die 250 is disposed on a side of the first plane 220, and is electrically connected to the first signal via 230, the second signal via 232, and the first plane 220 by using the first metal connector 252. The die 250 may be further electrically connected to the first via 222 by using the first metal connector 252.

In another implementing manner, the die 250 is disposed on a side of the third plane 226, and is electrically connected to the first signal via 230, the second signal via 232, and the first plane 220 by using the first metal connector 252. The first metal connector may be a bump.

The packaging apparatus 200 further includes a second metal connector 254 disposed on the other side of the substrate. The second metal connector 254 is configured to form an electrical connection between the packaging apparatus 200 and an external circuit 256. The external circuit 256 may be a PCB or another packaging apparatus. Both the first metal connector 252 and the second metal connector 254 may be solder bumps, for example, ball grid array (BGA) solder bumps or another metal connection material. As shown in FIG. 7, in an implementing manner, the second metal connector 254 is disposed on a surface that is of the packaging apparatus 200 and that is close to the third plane 226, that is, the die 250 and the PCB 256 are respectively disposed on two sides of the packaging apparatus 200. In another implementing manner, the second metal connector 254 is disposed on a surface that is of the packaging apparatus 200 and that is close to the first plane 220, that is, the die 250 and the PCB 256 are respectively disposed on one side of the packaging apparatus 200.

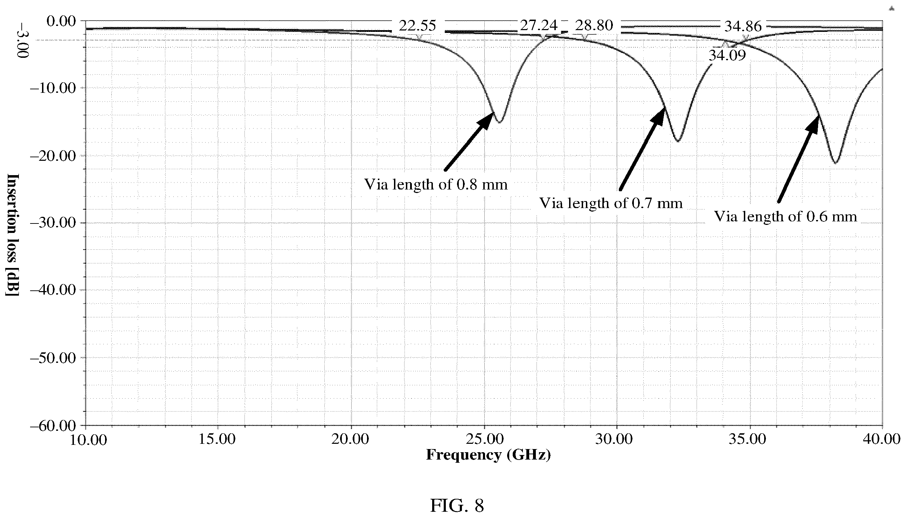

FIG. 8 shows a simulation result of a common-mode insertion loss of the packaging apparatus 200. A horizontal coordinate represents a frequency of a common-mode signal, and a vertical coordinate represents an insertion loss of the common-mode signal. Different common-mode suppression via lengths correspond to different common-mode signal insertion losses. When a common-mode suppression via length is 0.8 mm, a 3 dB filtering band corresponding to the length is 22.55 GHz to 27.24 GHz, and in this case, common-mode filtering of a bandwidth of 4.69 GHz is implemented; when a common-mode suppression via length is 0.7 mm, a 3 dB filtering band corresponding to the length is 28.8 GHz to 34.55 GHz, and in this case, an effect of common-mode filtering of an ultra-wideband greater than 6 GHz can be implemented; or when a common-mode suppression via length is 0.6 mm, a 3 dB filtering band corresponding to the length is higher than 34.09 GHz.

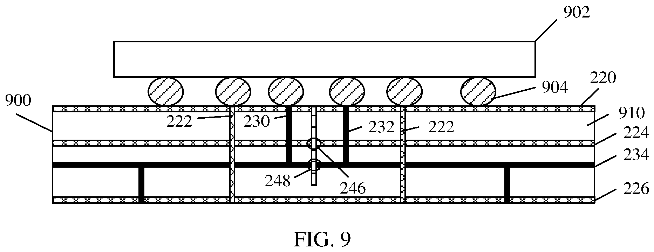

As shown in FIG. 9, an embodiment of this application further provides a multi-layer printed circuit board (PCB) 900. In an implementing manner, at least one chip 902 may be disposed on one side of the PCB 900, and the chip 902 forms an electrical connection to the PCB 900 by using a solder bump 904. In another implementing manner, the PCB 900 may further include at least one chip disposed on the other side of the PCB 900. The chip may use any packaging apparatus provided in the embodiments of this application, or may use a packaging apparatus in the conventional technology. The PCB 900 includes a substrate 910, and a first plane 220, a first signal via 230, a second signal via 232, and a first common-mode suppression via 240 that are disposed in the substrate 910. The substrate 910 may be a PCB implemented by using a copper-clad foil laminate. The first signal via 230 and the second signal via 232 are differential signal vias and are configured to transmit differential signals. The differential signals are signals input from the PCB 900 to the chip 902, or signals input from the chip 902 to the PCB 900. One end of the first signal via 230 and one end of the second signal via 232 may be respectively and electrically connected to a first signal layer 234 disposed in the substrate 910, and the other end of the first signal via 230 and the other end of the second signal via 232 may be electrically connected to differential signal pins of the chip 902, another external circuit, or a part/component. The first plane 220, the first signal via 230, the second signal via 232, and the first common-mode suppression via 240 may be the structures described in any embodiment of this application, and meet the positional relationship described in any embodiment of this application.

Further, the PCB 900 may further include the first via 222, the second plane 224, the third plane 226, the first signal layer 234, the second common-mode suppression via 242, the first anti-pad 246, and the second anti-pad 248 that are described in any embodiment of this application. The structures and positional relationships are the same as those in the packaging apparatus 200, and details are not described herein again.

In addition to the differential signals, there are also common-mode signals (namely, common-mode noise) in the first signal via 230 and the second signal via 232. The differential signals and the common-mode signals respectively generate different electric fields. Because the first common-mode suppression via 240 is disposed between the first signal via 230 and the second signal via 232, a first end of the first common-mode suppression via 240 is electrically connected to the first plane 220, and the other portions of the first common-mode suppression via 240 are insulated from the surrounding media, the first common-mode suppression via 240 forms a resonant circuit in the electric field generated by the common-mode signals, thereby exciting a resonance characteristic of the common-mode signals in the first signal via 230 and the second signal via 232, and suppressing the common-mode signals while retaining the differential signals. Compared with a manner in the conventional technology in which common-mode suppression is implemented by using a filter trace and an additional ground via, a manner in this application in which common-mode noise is suppressed by using the first common-mode suppression via 240 has a relatively simple requirement for a processing technique, and does not require an additional filter trace, thereby reducing physical space occupied by the PCB 900, being favorable to miniaturization of the PCB 900, and reducing manufacturing costs of the PCB 900.

## Claims

1. A common-mode suppression packaging apparatus, wherein the packaging apparatus comprises a substrate, and a first plane, a first signal via, a second signal via, and a first via that are disposed in the substrate, wherein
the first signal via and the second signal via are configured to transmit differential signals; and
the first via is disposed between the first signal via and the second signal via, a first end of the first via is electrically connected to the first plane, other portions of the first via other than the first end are insulated from surrounding media, at least a portion of the first via is located on a same horizontal plane as the first signal via and the second signal via, and the first plane is a ground layer or a power layer.

2. The packaging apparatus according to claim 1, wherein the packaging apparatus further comprises a second via disposed between the first signal via and the second signal via, a first end of the second via is electrically connected to the first plane, other portions of the second via other than the first end are insulated from surrounding media, at least a portion of the second via is located on a same horizontal plane as the first signal via and the second signal via, the first via and the second via are respectively disposed on two sides of a first virtual plane, and the first virtual plane is a plane passing through a central axis of the first signal via and a central axis of the second signal via.

3. The packaging apparatus according to claim 2, wherein both a central axis of the first via and a central axis of the second via are located on a second virtual plane, and the second virtual plane is a plane with respect to which the first signal via and the second signal via are symmetrical.

4. The packaging apparatus according to claim 2 or 3, wherein the first via and the second via are symmetrical with respect to the first virtual plane.

5. The packaging apparatus according to any one of claims 2 to 4, wherein the packaging apparatus further comprises a second plane, the first via and the second via respectively pass through the second plane, the first via and the second via are kept isolated from the second plane by a first anti-pad and a second anti-pad that are disposed on the second plane, respectively, and the second plane is a ground layer or a power layer.

6. The packaging apparatus according to claim 5, wherein both the first plane and the second plane are ground layers, and the packaging apparatus further comprises a ground via disposed in the substrate, wherein
the ground via is electrically connected to the first plane and the second plane.

7. The packaging apparatus according to any one of claims 2 to 6, wherein the packaging apparatus further comprises a signal layer, one end of the first signal via and one end of the second signal via are electrically connected to the signal layer respectively, the first via and the second via respectively pass through the signal layer, and the first via and the second via are kept isolated from the signal layer by a third anti-pad and a fourth anti-pad that are disposed on the signal layer, respectively.

8. The packaging apparatus according to any one of claims 1 to 7, wherein the packaging apparatus further comprises a die and a first metal connector that are disposed on one side of the substrate, and the die is electrically connected to the first signal via, the second signal via, and the first plane by using the first metal connector.

9. The packaging apparatus according to any one of claims 1 to 8, wherein the packaging apparatus further comprises a second metal connector disposed on the other side of the substrate, and the packaging apparatus is electrically connected to a printed circuit board by using the second metal connector.

10. A common-mode suppression printed circuit board, wherein the printed circuit board comprises a substrate, and a first plane, a first signal via, a second signal via, and a first via that are disposed in the substrate, wherein
the first signal via and the second signal via are configured to transmit differential signals; and
the first via is disposed between the first signal via and the second signal via, a first end of the first via is electrically connected to the first plane, other portions of the first via other than the first end are insulated from surrounding media, at least a portion of the first via is located on a same horizontal plane as the first signal via and the second signal via, and the first plane is a ground layer or a power layer.

11. The printed circuit board according to claim 10, wherein the printed circuit board further comprises a second via disposed between the first signal via and the second signal via, a first end of the second via is electrically connected to the first plane, other portions of the second via other than the first end are insulated from surrounding media, at least a portion of the second via is located on a same horizontal plane as the first signal via and the second signal via, the first via and the second via are respectively disposed on two sides of a first virtual plane, and the first virtual plane is a plane passing through a central axis of the first signal via and a central axis of the second signal via.

12. The printed circuit board according to claim 11, wherein both a central axis of the first via and a central axis of the second via are located on a second virtual plane, and the second virtual plane is a plane with respect to which the first signal via and the second signal via are symmetrical.

13. The printed circuit board according to claim 11 or 12, wherein the first via and the second via are symmetrical with respect to the first virtual plane.

14. The printed circuit board according to any one of claims 11 to 13, wherein the printed circuit board further comprises a second plane, the first via and the second via respectively pass through the second plane, the first via and the second via are kept isolated from the second plane by a first anti-pad and a second anti-pad that are disposed on the second plane, respectively, and the second plane is a ground layer or a power layer.

15. The printed circuit board according to claim 14, wherein both the first plane and the second plane are ground layers, and the printed circuit board further comprises a ground via disposed in the substrate, wherein
the ground via is electrically connected to the first plane and the second plane.

16. The printed circuit board according to any one of claims 11 to 15, wherein the printed circuit board further comprises a signal layer, one end of the first signal via and one end of the second signal via are respectively and electrically connected to the signal layerrespectively, the first via and the second via respectively pass through the signal layer, and the first via and the second via are kept isolated from the signal layer by a third anti-pad and a fourth anti-pad that are disposed on the signal layer, respectively.
